# EUROPEAN PATENT APPLICATION

(11) **EP 4 568 106 A1**
(43) Date of publication of application: **11.06.2025**
(21) Application number: 24196144.0
(22) Date of filing: 23.08.2024
(51) Int. Cl.: H03F 1/08, H03F 3/08

(54) **TRANSIMPEDANCE AMPLIFIER AND PHOTODETECTION DEVICE**

(30) Priority: 08.12.2023 JP 2023207602
(71) Applicant: Kabushiki Kaisha Toshiba, Tokyo 105-0023 (JP)
(72) Inventor: ITAKURA, Tetsuro, Minato-ku, Tokyo, 105-0023 (JP); MIWA, Shuhei, Minato-ku, Tokyo, 105-0023 (JP); SUGIMOTO, Toshiki, Minato-ku, Tokyo, 105-0023 (JP); TA, Tuan Thanh, Minato-ku, Tokyo, 105-0023 (JP); KONDO, Satoshi, Minato-ku, Tokyo, 105-0023 (JP)
(74) Representative: Hoffmann Eitle

(57) **Abstract**

A transimpedance amplifier includes an input terminal, a first transistor having a source connected to the input terminal, a first current-voltage conversion circuit, a first voltage-current conversion circuit and a second voltage-current conversion circuit that convert a voltage corresponding to an output voltage of the first current-voltage conversion circuit into a current, an inverting amplifier circuit having an input node connected to the source or the emitter of the first transistor and an output node connected to a gate or a base of the first transistor, a second current-voltage conversion circuit that converts an output current of the second voltage-current conversion circuit into a voltage, and an output terminal that outputs the voltage converted by the second current-voltage conversion circuit, wherein the output current of the first voltage-current conversion circuit is fed back to the source or the emitter of the first transistor.

## Description

### FIELD

Examples of the present invention relate to a transimpedance amplifier and a photodetection device.

### BACKGROUND

In order to detect laser reflected light in a light detection and ranging (LiDAR) or an optical signal of optical communication or the like, it is known to use a photodiode (hereinafter, PD) that converts an optical signal into a current signal, a transimpedance amplifier (hereinafter, TIA) that converts a current signal into a voltage signal, or a photodetection device using these.

In order to transmit a signal over a wide band, for example, a method of terminating a transmission path with 50 Ω has been proposed. However, when the input resistance value of the TIA is large, a fluctuation range of the input resistance value of the TIA due to manufacturing variations becomes large, so that the TIA is not correctly terminated, and frequency characteristics fluctuate.

### BRIEF DESCRIPTION OF THE DRAWINGS

FIG. 1 is a circuit diagram illustrating an example of a transimpedance amplifier according to an example;
FIG. 2 is a circuit diagram illustrating a modification of a transimpedance amplifier according to an example;
FIG. 3A is a circuit diagram illustrating a modification of a transimpedance amplifier according to an example;
FIG. 3B is a circuit diagram illustrating a modification of a transimpedance amplifier according to an example;
FIG. 4 is a circuit diagram illustrating a modification of a transimpedance amplifier according to an example;
FIG. 5 is a circuit diagram illustrating a modification of a transimpedance amplifier according to an example;
FIG. 6 is a circuit diagram illustrating a modification of a transimpedance amplifier according to an example;
FIG. 7 is a circuit diagram illustrating an example of a photodetection device according to an example;
FIG. 8A is a circuit diagram illustrating a modification of a photodetection device according to an example;
FIG. 8B is a circuit diagram illustrating a modification of a photodetection device according to an example;
FIG. 9 is a circuit diagram illustrating a modification of a photodetection device according to an example;
FIG. 10 is a circuit diagram illustrating a modification of a photodetection device according to an example;
FIG. 11 is a circuit diagram illustrating a modification of a photodetection device according to an example;
FIG. 12 is a circuit diagram illustrating a modification of a photodetection device according to an example;
FIG. 13A is a block diagram illustrating an example of an electronic device according to an example;
FIG. 13B is a block diagram illustrating an example of an electronic device according to an example; and
FIG. 14 is a perspective view illustrating an example of an electronic device according to an example.

### DETAILED DESCRIPTION

According to one example, a transimpedance amplifier includes:
an input terminal;
a first transistor having a source or an emitter connected to the input terminal;
a first current-voltage conversion circuit;
a first voltage-current conversion circuit and a second voltage-current conversion circuit that convert a voltage corresponding to an output voltage of the first current-voltage conversion circuit into a current;
an inverting amplifier circuit having an input node connected to the source or the emitter of the first transistor and an output node connected to a gate or a base of the first transistor;
a second current-voltage conversion circuit that converts an output current of the second voltage-current conversion circuit into a voltage; and
an output terminal that outputs the voltage converted by the second current-voltage conversion circuit, wherein
the output current of the first voltage-current conversion circuit is fed back to the source or the emitter of the first transistor.

Hereinafter, examples will be described with reference to the drawings. Note that, in the following description, components that exhibit the same or similar functions are denoted by the same reference numerals throughout all the drawings, and redundant description will be omitted. In addition, each drawing is a schematic view for promoting the description of the example and the understanding thereof, and the shape, size, ratio, and the like are different from those of the actual device, but these can be appropriately modified in design in consideration of the following description and known techniques.

### (First Example)

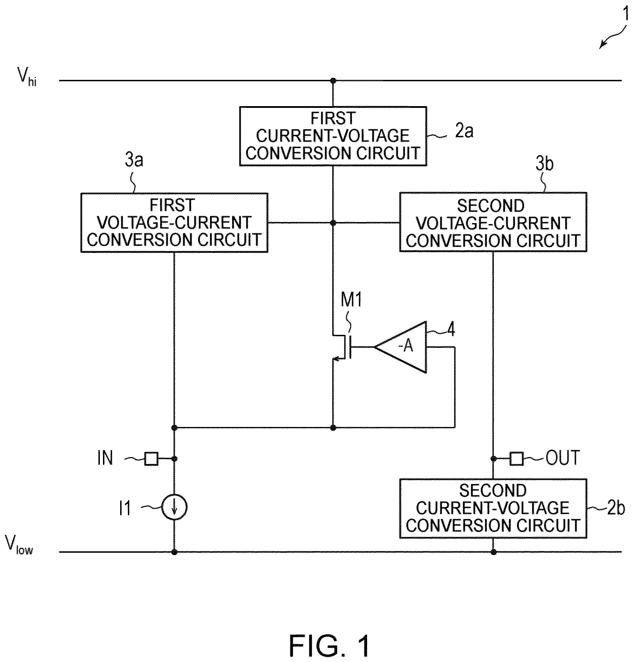

According to a first example, a transimpedance amplifier (TIA) is provided. FIG. 1 is a circuit diagram of a TIA 1 according to the first example. A TIA 1 of FIG. 1 includes an input terminal IN, an output terminal OUT, a first current-voltage conversion circuit 2a, a second current-voltage conversion circuit 2b, a first voltage-current conversion circuit 3a, a second voltage-current conversion circuit 3b, a current source I1, a transistor M1, and an inverting amplifier circuit 4. In FIG. 1, the high potential side is denoted by Vₕᵢ, and the low potential side is denoted by V_{low}. However, the high potential side may be connected to, for example, a power supply, and the low potential side may be grounded, for example. The same applies to drawings appearing thereafter.

A source of the transistor M1 is connected to the input terminal IN, and is also connected to an input node of the inverting amplifier circuit 4, an output node of the first voltage-current conversion circuit 3a, and the current source I1. A drain of the transistor M1 is connected to input nodes of the first voltage-current conversion circuit 3a and the second voltage-current conversion circuit 3b, and is also connected to the first current-voltage conversion circuit 2a.

The transistor M1 may be, for example, a bipolar transistor or a field effect transistor. Here, it is assumed that the transistor M1 is a field effect transistor. The transistor M1 is, for example, an NMOS transistor, but may have any conductivity type. The same applies to other transistors appearing thereafter.

The first current-voltage conversion circuit 2a is connected to input nodes of the first voltage-current conversion circuit 3a and the second voltage-current conversion circuit 3b and Vₕᵢ (for example, a power supply). The current source I1 and the second current-voltage conversion circuit 2b are connected to V_{low} (for example, ground).

The output node of the first voltage-current conversion circuit 3a is connected to the input terminal IN, the source of the transistor M1, and the input node of the inverting amplifier circuit 4. An output node of the second voltage-current conversion circuit 3b is connected to the second current-voltage conversion circuit 2b and is also connected to the output terminal OUT. The first voltage-current conversion circuit 3a and the second voltage-current conversion circuit 3b can be replaced with, for example, a transistor having an input node as a gate and an output node as a drain. The first current-voltage conversion circuit 2a and the second current-voltage conversion circuit 2b can be replaced with a current source or a resistor.

The gain of the inverting amplifier circuit 4 is expressed as -A times where a factor A is an amplification degree. An output node of the inverting amplifier circuit 4 is connected to a gate of the transistor M1. The inverting amplifier circuit 4 can be replaced with a transistor and a current source.

The operation of the TIA 1 illustrated in FIG. 1 will be described. For example, when an input current is applied in a direction in which a current is drawn from the input terminal IN, a part of the applied current is converted into a voltage by the first current-voltage conversion circuit 2a via the transistor M1, and the converted voltage is converted into a current by the first voltage-current conversion circuit 3a and fed back to the input terminal IN, so that fluctuation of the input terminal voltage is suppressed. In addition, the inverting amplifier circuit 4 is inputted an input terminal voltage and is fed back to the gate of the transistor M1, and this feedback loop also serves to suppress fluctuation of the source voltage of the transistor M1, that is, fluctuation of the input terminal voltage. As described above, the configuration of the double feedback loop including the feedback loop including the input terminal IN, the transistor M1, the first current-voltage conversion circuit 2a, and the first voltage-current conversion circuit 3a and the feedback loop including the inverting amplifier circuit 4 and the transistor M1 makes it possible to further suppress the fluctuation of the input terminal voltage when the input current is applied.

Most of the input current flows through the first voltage-current conversion circuit 3a. Assuming that the input current is Iᵢₙ, the conversion coefficient of the first voltage-current conversion circuit 3a is gₘ₁, and the conversion coefficient of the second voltage-current conversion circuit 3b is gₘ₅, the output current of the second voltage-current conversion circuit 3b is gₘ₅Iᵢₙ/gₘ₁, which is converted into a voltage by the second current-voltage conversion circuit 2b (for example, the resistor R1 having the resistance value R₁), and a voltage signal of gm₅R₁Iᵢₙ/gₘ₁ is output from the output terminal OUT.

The conversion coefficient of the first voltage-current conversion circuit 3a is gₘ₁, the transconductance of the transistor M1 is gₘ₂, the output conductance of the transistor M1 is gₒ₂, and the conversion coefficient of the first current-voltage conversion circuit 2a is 1/gₒ₄ as the reciprocal of the conductance. Therefore, using these coefficients and the amplification degree A of the inverting amplifier circuit 4, the input resistance of the TIA 1 is approximately obtained as (gₒ₂ + gₒ₄)/(Agₘ₁gₘ₂). Here, for example, when gₘ₁ ≈ 1 mS, g_{m2/}(gₒ₂ + gₒ₄) ≈ 20, and A = 20, the input resistance of the TIA 1 is 2.5 Ω, and the termination resistance can be 50 Ω by connecting a resistor of 47.5 Ω in series to the input node of the TIA 1. By reducing the input resistance, even if the input resistance value of the TIA 1 varies due to manufacturing variations, temperature changes, power supply voltage variations, and the like, the variation range as the termination resistance value can be reduced, and disturbance of the frequency characteristics can be alleviated.

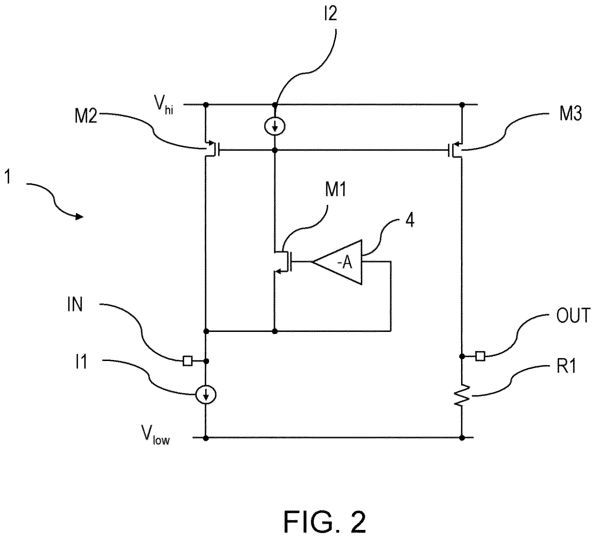

FIG. 2 is a circuit diagram illustrating a first modification of a transimpedance amplifier according to the first example. A TIA 1 of FIG. 2 embodies the configuration of each unit in the TIA 1 of FIG. 1. In the TIA 1 of FIG. 2, the first voltage-current conversion circuit 3a and the second voltage-current conversion circuit 3b are constituted by a transistor M2 and a transistor M3, respectively, and the first current-voltage conversion circuit 2a and the second current-voltage conversion circuit 2b are constituted by a current source I2 and a resistor R1, respectively.

Sources of the transistors M2 and M3 are connected to, for example, a power supply, and gates of the transistors M2 and M3 are connected to the current source I2 and the drain of the transistor M1. A drain of the transistor M2 is connected to the input terminal IN and the input node of the inverting amplifier circuit 4, and a drain of the transistor M3 is connected to the output terminal OUT. The resistor R1 is grounded, for example. The transistors M2 and M3 are, for example, PMOS transistors.

The current conversion coefficients of the first voltage-current conversion circuit 3a and the second voltage-current conversion circuit 3b correspond to the transconductance of the transistor M2 and the transistor M3, respectively. In addition, the conductance, which is the reciprocal of the conversion coefficient of the first current-voltage conversion circuit 2a, corresponds to the output conductance of the current source 12. Similarly to the circuit diagram of FIG. 1, the disturbance of the frequency characteristic can be alleviated by reducing the input resistance.

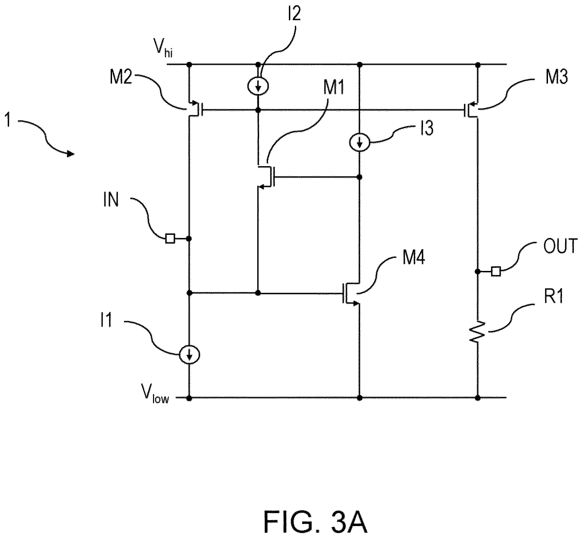

FIG. 3A is a circuit diagram illustrating a second modification of a transimpedance amplifier according to the first example. A TIA 1 in FIG. 3A embodies the configuration of the inverting amplifier circuit 4 in FIGS. 1 and 2, and the inverting amplifier circuit 4 is replaced with a common-source amplifier circuit using a transistor M4 and a current source (a third current-voltage conversion) I3.

A gate of the transistor M4 is connected to the input terminal IN and the source of the transistor M1, and a drain of the transistor M4 is connected to the current source I3 and the gate of the transistor M1. A source of the transistor M4 is grounded, for example. The transistor M4 is, for example, an NMOS transistor. The current source I3 is connected to the power supply and the gate of the transistor M1.

When the transconductance of the transistor M4 is gₘ₃, the output conductance of the transistor M4 is gₒ₃, and the output conductance of the current source I3 is gₒ₆, the gain of the inverting amplifier circuit 4 is expressed as -gₘ₃/(gₒ₃ + gₒ₆). Therefore, the input resistance of the TIA is approximately obtained as (gₒ₂ + gₒ₄)(gₒ₃ + gₒ₆)/(gₘ₁gₘ₂gₘ₃). Here, for example, when gₘ₁ ≈ 1 mS, gₘ₂/(gₒ₂ + gₒ₄) ≈ 20, and gₘ₃/(gₒ₃ + gₒ₆) ≈ 20, the input resistance of the TIA is 2.5 Ω. Therefore, the disturbance of the frequency characteristic can be alleviated by reducing the input resistance.

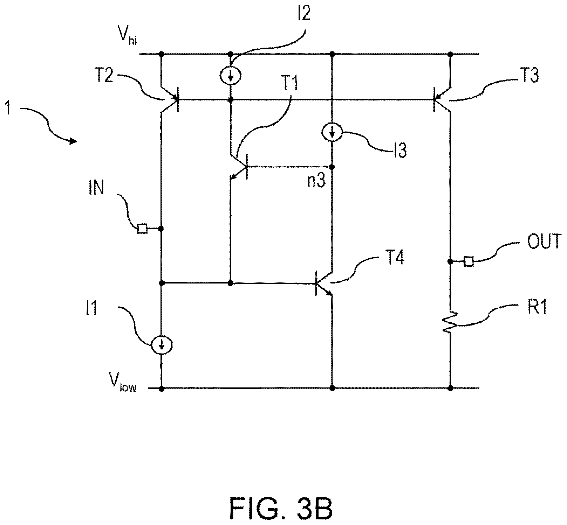

FIG. 3B is a circuit diagram illustrating a third modification of a transimpedance amplifier according to the first example. As illustrated in FIG. 3B, transistors M2 and M3 may be configured by pnp bipolar transistors T2 and T3, and transistors M1 and M4 may be configured by npn bipolar transistors T1 and T4. The gates, drains, and sources of the transistors M1 to M4 correspond to bases, collectors, and emitters of the bipolar transistors T1 to T4, respectively. Although not illustrated, for example, only the transistors M1 and M4 may be configured by the npn bipolar transistors T1 and T4.

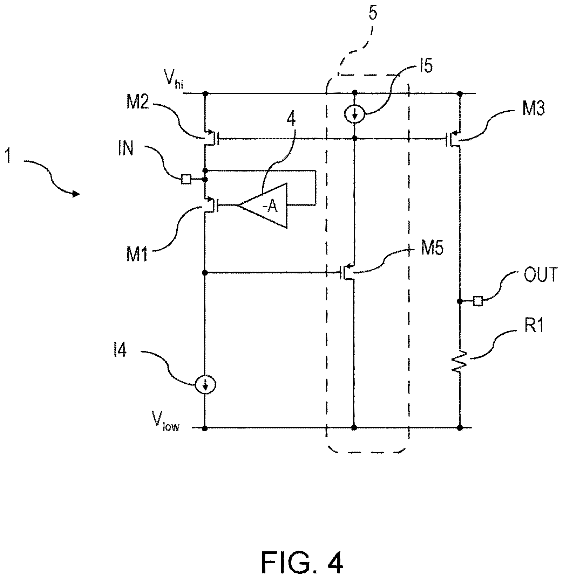

FIG. 4 is a circuit diagram illustrating a fourth modification of a transimpedance amplifier according to the first example. A TIA 1 of FIG. 4 is a specific example in a case where the transistor M1 is of the same PMOS type as the transistors M2 and M3. The voltage converted by the current-voltage conversion circuit (for example, the current source I4 operates as the first current-voltage circuit 2a) is applied to the gates of the transistor M2 and the transistor M3 via a level shift circuit 5 including the transistor M5 and the current source I5. The gate of the transistor M5 is connected to the drain of the transistor M1, and the source of the transistor M5 is connected to the gates of the transistors M2 and M3 and the current source I5. A drain of the transistor M5 is grounded. The transistor M5 is, for example, a PMOS transistor.

Since the signal gain of the level shift circuit 5 is 1 or nearly 1, the input resistance is the same as that of the circuit illustrated in FIG. 2, and can be approximately obtained as (gₒ₂ + gₒ₄)/(Agₘ₁gₘ₂). Since the input resistance is calculated similarly to the circuit diagram of FIG. 2, the disturbance of the frequency characteristic can be alleviated by reducing the input resistance.

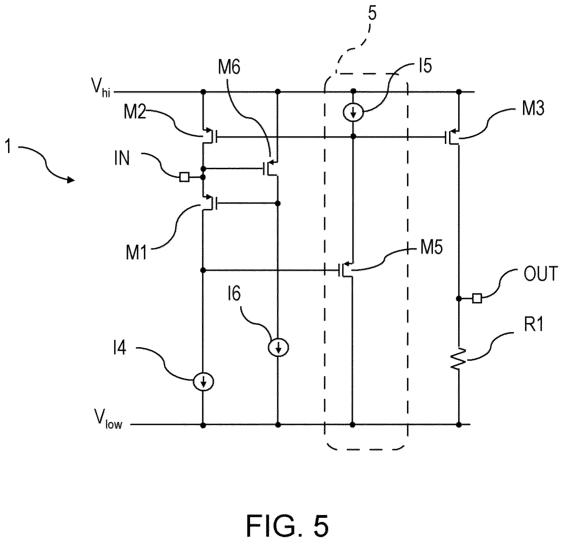

FIG. 5 is a circuit diagram illustrating a fifth modification of a transimpedance amplifier according to the first example. Similarly to FIG. 3A, a TIA 1 of FIG. 5 is obtained by replacing the inverting amplifier circuit 4 of FIG. 4 with a common-source amplifier circuit using a transistor M6 and a current source (a fourth current-voltage conversion circuit) I6. A gate of the transistor M6 is connected to the input terminal IN and the drain of the transistor M2, and a source of the transistor M6 is connected to the power supply. A drain of the transistor M6 is connected to the gate of the transistor M1 and the current source I6. The transistor M6 is, for example, a PMOS transistor.

When the transconductance of the transistor M6 is gₘ₃, the output conductance of the transistor M6 is gₒ₃, and the output conductance of the current source I6 is gₒ₆, the gain of the inverting amplifier circuit 4 is expressed as -gₘ₃/(gₒ₃ + gₒ₆). Therefore, the input resistance of the TIA is approximately obtained as (gₒ₂ + g_{b4})(g_{b3} + gₒ₆)/(gₘ₁gₘ₂gₘ₃). Since the input resistance is calculated similarly to the circuit diagram of FIG. 3A, the disturbance of the frequency characteristic can be alleviated by reducing the input resistance.

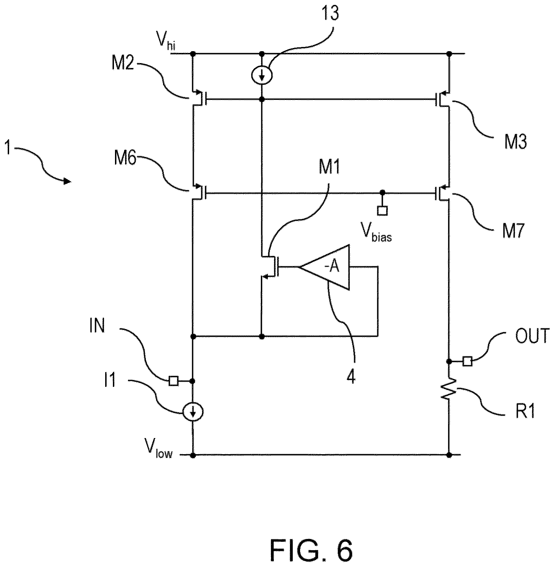

FIG. 6 is a circuit diagram illustrating a sixth modification of a transimpedance amplifier according to the first example. FIG. 6 illustrates an example in which common-gate or common-base amplifier circuits using the transistors M6 and M7 are introduced. The transistors M6 and M7 are, for example, PMOS transistors. The drain of the transistor M6 is connected to the source of the transistor M1, the input node of the inverting amplifier circuit 4, and the input terminal IN. The source of the transistor M6 is connected to the drain of the transistor M2. A drain of the transistor M7 is connected to the output terminal OUT. A source of the transistor M7 is connected to the drain of the transistor M3. The gates of the transistors M6 and M7 are connected to V_{bias}.

By applying the bias voltage from V_{bias} to the gates of the transistors M6 and M7 and connecting the sources of the transistors M6 and M7 to the drains of the transistors M2 and M3, respectively, the drain voltages of the transistors M2 and M3 can be almost the same. As a result, an error generated in the output current can be reduced.

Since the TIA according to the first example reduces the input resistance of the TIA, even if the input resistance value of the TIA varies due to manufacturing variations, temperature changes, power supply voltage variations, and the like, the variation range as the termination resistance value can be reduced, and disturbance of the frequency characteristics can be alleviated.

### (Second Example)

According to a second example, a photodetection device is provided. The photodetection device according to the second example includes the TIA according to the first example.

The photodetection device 6 may include a passive element. Examples of the passive element include a resistor and a capacitor. A single passive element can be used, or a plurality of passive elements can be provided. A method for connecting passive elements in a photoelectric conversion circuit 7 is not limited.

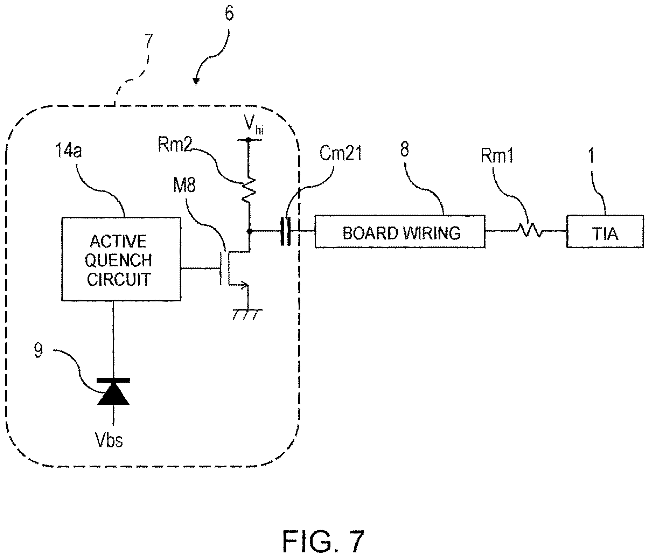

FIG. 7 is a circuit diagram illustrating a photodetection device according to the second example. The photodetection device 6 of FIG. 7 includes the photoelectric conversion circuit 7, any TIA 1 illustrated in FIGS. 1 to 6, a resistor Rm1 having one end connected in series to an input node of the TIA 1, and a board wiring 8 connecting an output node of the photoelectric conversion circuit 7 and the other end of the resistor Rm1.

The photoelectric conversion circuit 7 in FIG. 7 includes, for example, a photodiode 9 that inputs an optical signal, an active quench circuit 14a that controls a voltage applied to the photodiode 9 and also outputs a voltage signal according to the optical signal input to the photodiode 9, a transistor M8 to which a voltage signal output from the active quench circuit 14a is applied to a gate, a resistor Rm2 connected between a drain of the transistor M8 and a power supply, and a capacitor Cm21 that does not pass a DC component but passes only a signal component. In this configuration, the transistor M8 corresponds to an output node of the photoelectric conversion circuit 7. As the photodiode 9, for example, an avalanche photodiode, a PN type photodiode, a PIN type photodiode, or the like can be used.

The board wiring 8 may include a cable and a connector. In the board wiring 8, a parasitic inductance component that enters in series and a parasitic capacitance component that enters with respect to ground is formed. Therefore, frequency characteristics in a high-frequency frequency band are disturbed. The resistor Rm2 terminates the output node side of the photoelectric conversion circuit 7, and the resistor Rm1 serves as an input resistance of the TIA 1 and terminates the input node side of the TIA 1. For example, the board wiring 8 is manufactured so as to have a characteristic impedance of 50 Ω and satisfy the resistor ≈ (the resistor Rm2 + the input resistance of the TIA 1) ≈ 50 Ω, so that it is possible to alleviate the disturbance in the high-frequency frequency band.

In the TIA 1 illustrated in FIGS. 1 to 6, since the input resistance of the TIA is sufficiently smaller than the resistor Rm1, the variation in the input resistance value of the TIA 1 due to manufacturing variations, temperature variations, and power supply voltage variations can be suppressed to be small. Therefore, since the variation in the termination resistance value on the TIA side (the resistor Rm1 + the input resistance of TIA) due to the manufacturing variations, the temperature variations, and the power supply voltage variations can be almost ignored, it is possible to alleviate the disturbance of the frequency characteristic due to the manufacturing variations, the temperature variations, and the power supply voltage variations.

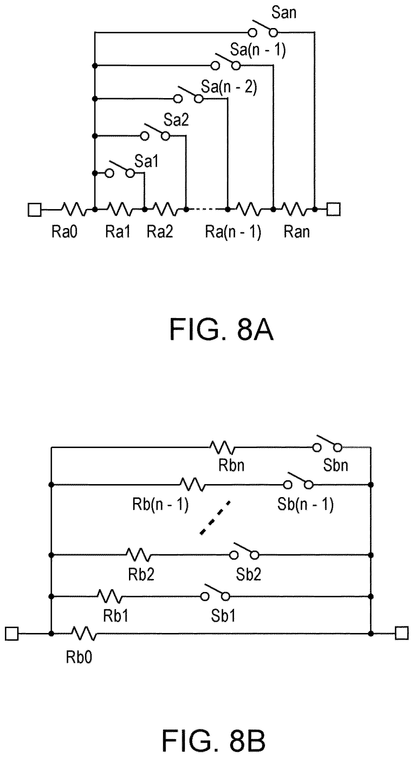

FIGS. 8A and 8B are diagrams illustrating an example of detailed configuration of the resistor Rm1 in Figure 7. FIG. 8A is a circuit diagram illustrating the resistor Rm1 according to a first concrete example. FIG. 8B is a circuit diagram illustrating the resistor Rm1 according to a second concrete example. As illustrated in FIGS. 8A and 8B, in a case where the resistor Rm1 connected to the input node of the TIA is integrated together with the TIA, in order to correct manufacturing variation of the resistor Rm1, the resistor Rm1 may be configured by a plurality of switches and a plurality of resistors, and the resistance value may be corrected by selecting the switch. FIG. 8A illustrates an example in which the resistor Rm1 includes a plurality of resistors Ra0 to Ran connected in series and selection switches Sa1 to San, and switches Sa1 to San for selecting connection between one end of Ra0 and one end of each of Ra1 to Ran are provided. The resistance value can be adjusted by selecting opening and closing of the switches Sa1 to San. FIG. 8B illustrates a configuration in which each resistors Rb1 to Rbn and each switches Sb1 to Sbn connected in series. The each pairs of resistors Rb1 to Rbn and switches Sb1 to Sbn are connected in parallel between both ends of Rb0. The resistance value can be adjusted by selecting opening and closing of the switches Sb1 to Sbn. The configuration of the resistor Rm1 may be possible the configuration of FIG. 8A or FIG. 8B, or the configuration combined FIG. 8A and 8B.

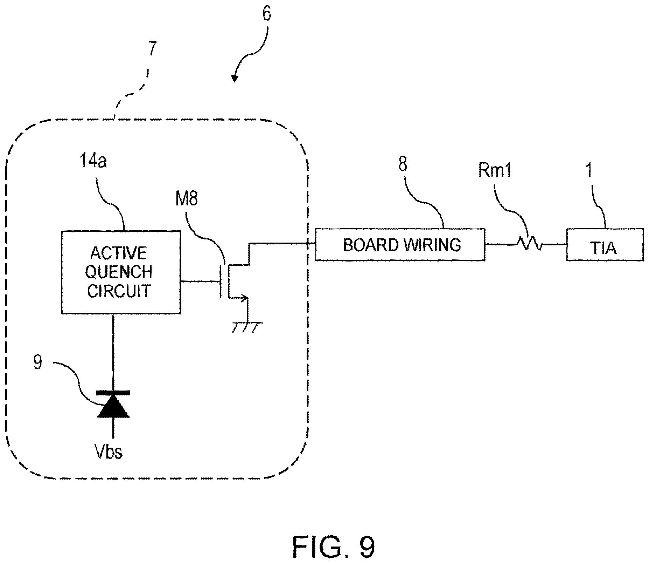

FIG. 9 is a circuit diagram illustrating a first modification of a photodetection device according to the second example. As illustrated in FIG. 9, the resistor Rm2 and the capacitor Cm21 on the output node side of the photoelectric conversion circuit 7 in FIG. 7 may be removed, and the output node of the photoelectric conversion circuit 7 and the input node of the TIA 1 may be DC-coupled to each other to terminate only the TIA 1 side. In FIG. 7, for example, when the resistor Rm2 = (the resistor Rm1 + the input resistance of TIA) =50 Ω, half of the signal current output from the drain of the transistor M8 flows to the Rm2, and the signal current flowing into the TIA 1 side is halved. However, in FIG. 9, since the entire signal current output from the drain of the transistor M8 flows into the TIA 1, the signal amplitude increases and the resistance to noise is improved.

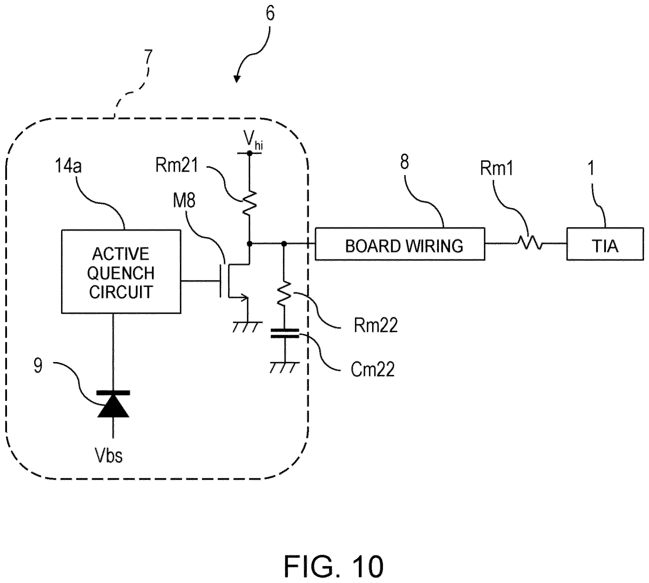

FIG. 10 is a circuit diagram illustrating a second modification of a photodetection device according to the second example. The resistor Rm2 on the output node side of the photoelectric conversion circuit 7 in FIG. 7 may include a resistor Rm21 and a resistor Rm22 as illustrated in FIG. 10. The resistor Rm21 is connected to the power supply, the drain of the transistor M8, the resistor Rm22, and the board wiring 8, and the resistor Rm22 is connected to the drain of the transistor M8, the board wiring 8, and a capacitor Cm22. The capacitor Cm22 is grounded.

In such a configuration, Rm21 and Rm22 may be selected so as to satisfy Rm21Rm22/(Rm21 + Rm22) = Rm2, and the capacitor Cm22 may be selected so as to satisfy 1/(2nfCm22) < < 1 at the frequency f of the signal band.

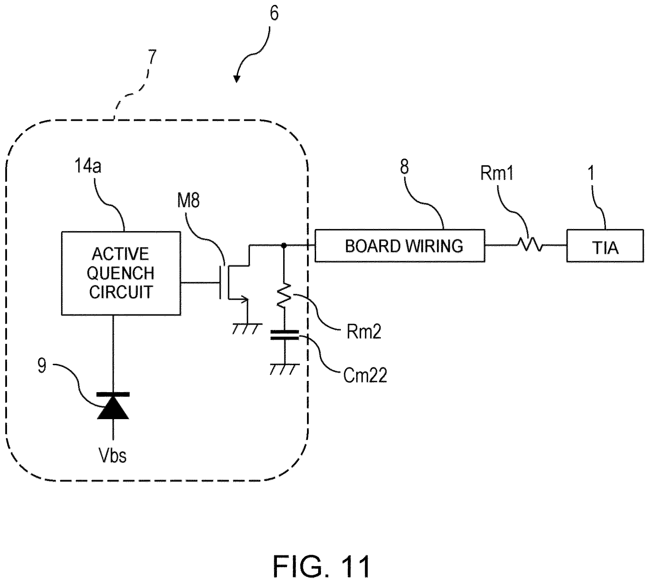

FIG. 11 is a circuit diagram illustrating a third modification of a photodetection device according to the second example. FIG. 11 illustrates an example in which the resistor Rm2 and the capacitor Cm22 are connected as passive elements between the transistor M8 and the board wiring 8. The resistor Rm2 is connected to the drain of the transistor M8, the board wiring 8, and the capacitor Cm22. The capacitor Cm22 is grounded. The capacitor Cm22 may be selected such that 1/(2nfCm22) << 1 is satisfied at the frequency f of the signal band, so that the output node side of the photoelectric conversion circuit 7 can be terminated by the resistor Rm2 in the signal band. With this configuration, it is possible to avoid noise injection from the power supply.

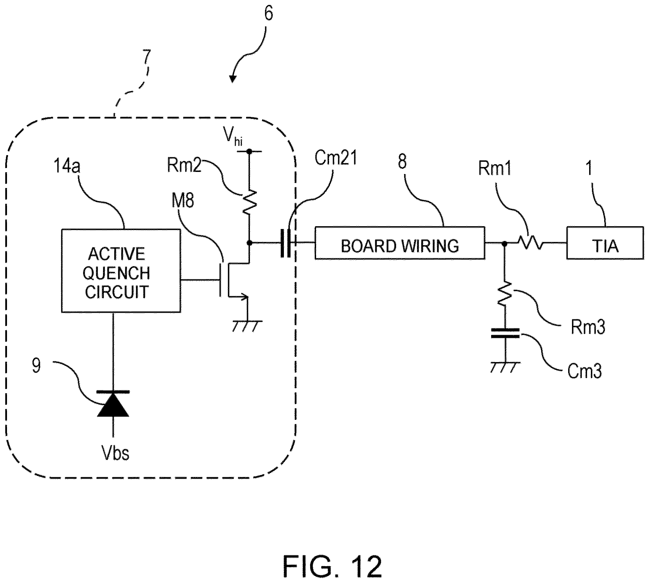

FIG. 12 is a circuit diagram illustrating a fourth modification of a photodetection device according to the second example. FIG. 12 illustrates an example in which a resistor Rm3 and a capacitor Cm3 are further added as passive elements in addition to the configuration of FIG. 7. The resistor Rm3 is connected to the board wiring 8, the resistor Rm1, and the capacitor Cm3. The capacitor Cm3 is grounded. The capacitor Cm3 may be selected such that 1/(2nfCm3) < < 1 is satisfied at the frequency f of the signal band, so that the input node side of the TIA 1 can be terminated by the resistor Rm3 in the high frequency band. With this configuration, the termination characteristics on the TIA 1 side in the high frequency band can be improved.

The photodetection device of the second example includes the transimpedance amplifier of the first example. As a result, it is possible to alleviate the disturbance of the frequency characteristics.

### (Third Example)

According to a third example, an electronic device is provided. The electronic device according to the third example includes the photodetection device according to the second example.

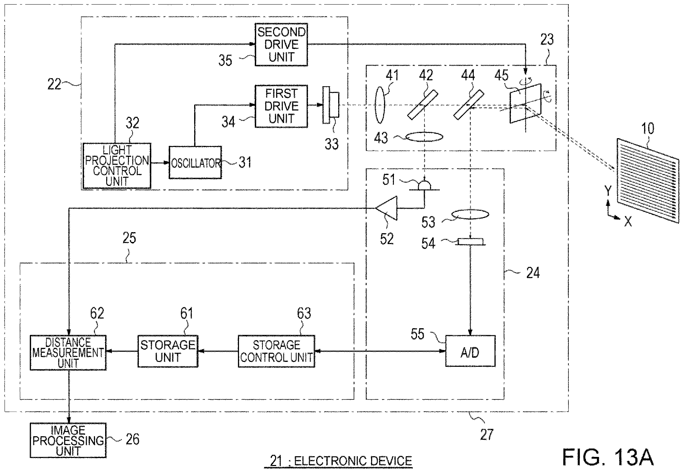

The electronic device according to the third example may measure a distance by, for example, a time of flight (ToF) method. FIG. 13A is a block diagram illustrating a schematic configuration of an electronic device 21 according to the third example. FIG. 13A illustrates the electronic device 21 including a light receiving unit 24 incorporating a photodetection device 6. Specifically, the photodetection device 6 according to the third example is used for a photodetector 51 and a light receiving sensor 54 of the light receiving unit 24. The electronic device 21 in FIG. 13A includes a light projecting unit (a light projector) 22, a light control unit 23, a light receiving unit (a light receiver) 24, a signal processing unit 25, and an image processing unit 26. Among them, the light projecting unit 22, the light control unit 23, the light receiving unit 24, and the signal processing unit 25 constitute a distance measuring device 27. At least a part of the electronic device 21 in FIG. 13A can be configured by one or a plurality of semiconductor integrated circuits (ICs). For example, the signal processing unit 25 and the image processing unit 26 may be integrated inside one semiconductor chip, or may be integrated in that semiconductor chip including the light receiving unit 24. In addition, the light projecting unit 22 may also be integrated on that semiconductor chip.

The light projecting unit 22 projects the first light. The first light is, for example, laser light in a predetermined frequency band. The laser light is coherent light having a uniform phase and frequency. The light projecting unit 22 intermittently projects the pulsed first light at a predetermined cycle. The cycle in which the light projecting unit 22 projects the first light is a time interval equal to or longer than the time required for the distance measuring device 27 to measure the distance on the basis of one pulse of the first light.

The light projecting unit 22 includes an oscillator 31, a light projection control unit 32, a light source 33, a first drive unit 34, and a second drive unit 35. In response to an instruction from the light projection control unit 32, the oscillator 31 generates an oscillation signal corresponding to the cycle of projecting the first light. The first drive unit 34 intermittently supplies power to the light source 33 in synchronization with the oscillation signal. The light source 33 intermittently emits the first light based on the power from the first drive unit 34. The light source 33 may be a laser element that emits a single laser beam or a laser unit that simultaneously emits a plurality of laser beams. The light projection control unit 32 controls the oscillator 31 and also controls the second drive unit 35 in synchronization with the oscillation signal. In response to an instruction from the light projection control unit 32, the second drive unit 35 supplies a drive signal synchronized with the oscillation signal to the light control unit 23.

The light control unit 23 controls a traveling direction of the first light emitted from the light source 33. In addition, the light control unit 23 controls a traveling direction of the received second light.

The light control unit 23 includes a first lens 41, a beam splitter 42, a second lens 43, a half mirror 44, and a scanning mirror 45.

The first lens 41 condenses the first light emitted from the light projecting unit 22 and guides the first light to the beam splitter 42. The beam splitter 42 branches the first light from the first lens 41 in two directions and guides the first light to the second lens 43 and the half mirror 44. The second lens 43 guides the split light from the beam splitter 42 to the light receiving unit 24. The reason why the first light is guided to the light receiving unit 24 is that the light receiving unit 24 detects the light projection timing.

The half mirror 44 passes the split light from the beam splitter 42 and guides the split light to the scanning mirror 45. In addition, the half mirror 44 reflects the second light including the reflected light incident on the electronic device 21 in the direction toward the light receiving unit 24.

The scanning mirror 45 rotationally drives the mirror surface in synchronization with the drive signal from the second drive unit 35 in the light projecting unit 22. As a result, the reflection direction of the split light (first light) that has passed through the half mirror 44 and entered the mirror surface of the scanning mirror 45 is controlled. By rotationally driving the mirror surface of the half mirror 44 at a constant cycle, the first light emitted from the light control unit 23 can be scanned in at least a one-dimensional direction. By providing the axes for rotationally driving the mirror surface in two directions, the first light emitted from the light control unit 23 can be scanned also in a two-dimensional direction. FIG. 13A illustrates an example in which the scanning mirror 45 scans the first light projected from the electronic device 21 in the X direction and the Y direction.

When an object 10 such as a human or a body is present within the scanning range of the first light projected from the electronic device 21, the first light is reflected by the object 10. At least a part of the reflected light reflected by the object 10 travels in the reverse direction along the substantially same path as the first light and enters the scanning mirror 45 in the light control unit 23. The mirror surface of the scanning mirror

45 is rotationally driven at a predetermined period, but since the laser light propagates at the speed of light, the reflected light from the object 10 enters the mirror surface while the angle of the mirror surface of the scanning mirror 45 hardly changes. The reflected light from the object 10 incident on the mirror surface is reflected by the half mirror 44 and received by the light receiving unit 24.

The light receiving unit 24 includes the photodetector 51, an amplifier 52, a third lens 53, a light receiving sensor 54, and an A/D converter 55. The photodetector 51 receives the light branched by the beam splitter 42 and converts the light into an electric signal. The photodetector 51 can detect the light projection timing of the first light. The amplifier 52 amplifies the electric signal output from the photodetector 51.

The third lens 53 forms an image of the second light reflected by the half mirror 44 on the light receiving sensor 54. The light receiving sensor 54 receives the second light and converts the second light into an electric signal. The light receiving sensor 54 includes a silicon photomultiplier (SiPM) 13 including an avalanche photodiode (APD) (not illustrated).

The A/D converter 55 samples the electric signal output from the light receiving sensor 54 at a predetermined sampling rate, performs A/D conversion, and generates a digital signal.

The signal processing unit 25 measures the distance to the object 10 that has reflected the first light, and stores a digital signal corresponding to the second light in the storage unit 61. The signal processing unit 25 includes a storage unit 61, a distance measurement unit (a processing circuitry) 62, and a storage control unit 63. The storage control unit 63 performs control to store the digital signal A/D converted by the A/D converter 55 in the storage unit 61.

The distance measurement unit 62 measures the distance to the object 10 on the basis of the first light and the reflected light. More specifically, the distance measurement unit 62 measures the distance to the object on the basis of the time difference between the light projection timing of the first light and the light reception timing of the reflected light included in the second light received by the light receiving sensor 54. That is, the distance measurement unit 62 measures the distance on the basis of the following Formula (1). distance = light speed × (light reception timing of reflected light - light projection timing of first light)/2

The "light reception timing of reflected light" in Expression (1) is more accurately the light reception timing of the peak position of the reflected light. The distance measurement unit 62 detects the peak position of the reflected light included in the second light on the basis of the digital signal generated by the A/D converter 55.

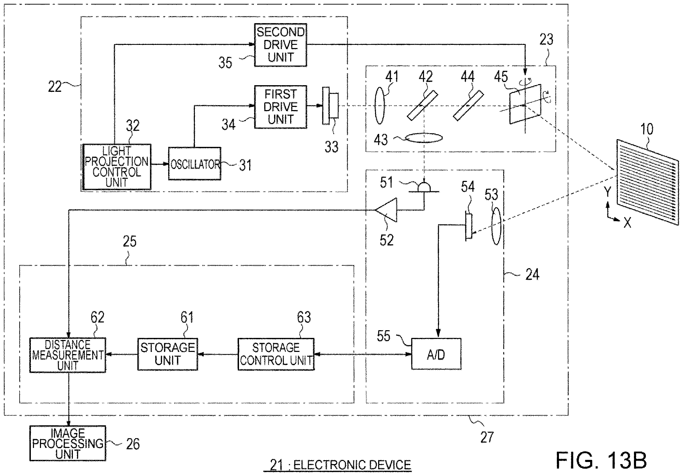

In the electronic device 21 of FIG. 13A, an example in which reflected light from the object 10 is reflected by the scanning mirror 45 and the half mirror 44 and guided to the light receiving unit 24 has been described. However, in a case of using the light receiving sensor 54 in which a plurality of SiPMs 13 is arranged in a two-dimensional direction, the present invention can be applied to the electronic device 21illustrated in FIG. 13B. FIG. 13B is a block diagram illustrating a schematic configuration of a modification of an electronic device 21 according to the third example. In the electronic device 21 of FIG. 13B, the reflected light from the object 10 is not guided to the light receiving unit 24 after being reflected by the scanning mirror 45 and the half mirror 44, but the reflected light from the object 10 is directly guided to the light receiving sensor 54 via the third lens 53.

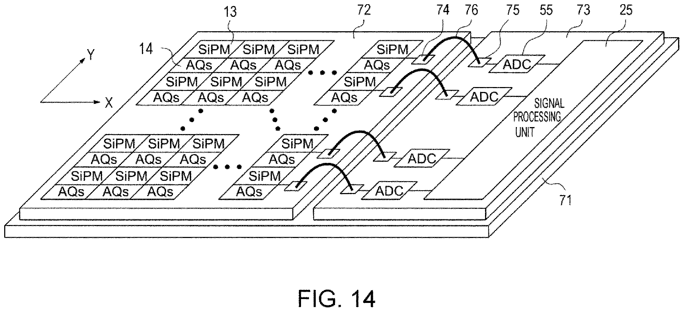

At least a part of the electronic device 21 of FIG. 13A or FIG. 13B can be configured by one or a plurality of semiconductor ICs. FIG. 14 is a schematic perspective view illustrating an example in which the light receiving unit 24 and the signal processing unit 25 in the electronic device 21 of FIG. 13A or 13B are arranged on one semiconductor substrate 71. A first die 72 and a second die 73 are provided on the semiconductor substrate 71 of FIG. 14. The light receiving sensor 54 in the light receiving unit 24 of FIG. 13A or 13B is disposed on the first die 72. The light receiving sensor 54 includes a plurality of SiPMs 13 and a plurality of active quenching circuit groups 14 arranged in the X direction and the Y direction. On the second die 73, the A/D converter (ADC) 55 in the light receiving unit 24 and the signal processing unit 25 in FIG. 13A or 13B are arranged. A pad 74 on the first die 72 and a pad 75 on the second die 73 are connected by a bonding wire 76.

The light projecting unit 22 and the light control unit 23 may be mounted on the semiconductor substrate 71 of FIG. 14. Alternatively, the light projecting unit 22 and the light control unit 23 may be mounted on a substrate different from the semiconductor substrate 71 of FIG. 14.

According to one or more examples described above, a transimpedance amplifier is provided. The transimpedance amplifier according to the examples can alleviate disturbance of frequency characteristics.

While certain examples have been described, these examples have been presented by way of example only, and are not intended to limit the scope of the disclosures. Indeed, the novel methods and systems described herein may be embodied in a variety of other forms; furthermore, various omissions, substitutions and changes in the form of the methods and systems described herein may be made without departing from the spirit of the disclosures. The accompanying claims and their equivalents are intended to cover such forms or modifications as would fall within the scope and spirit of the disclosures.

Hereinafter, the invention according to the example will be additionally described.
<1> A transimpedance amplifier (1) comprising:
   an input terminal (IN);
   a first transistor (M1) having a source or an emitter connected to the input terminal (IN);
   a first current-voltage conversion circuit (2a);
   a first voltage-current conversion circuit (3a) and a second voltage-current conversion circuit (3b) that convert a voltage corresponding to an output voltage of the first current-voltage conversion circuit (2a) into a current;
   an inverting amplifier circuit (4) having an input node connected to the source or the emitter of the first transistor (M1) and an output node connected to a gate or a base of the first transistor (M1);
   a second current-voltage conversion circuit (2b) that converts an output current of the second voltage-current conversion circuit (3b) into a voltage; and
   an output terminal (OUT) that outputs the voltage converted by the second current-voltage conversion circuit (2b), wherein
   the output current of the first voltage-current conversion circuit (3a) is fed back to the source or the emitter of the first transistor (M1).
<2> The transimpedance amplifier (1) according to <1>, wherein
   the first current-voltage conversion circuit (2a) and the second current-voltage conversion circuit (2b) each include at least one of a resistor (R1) and a current source (I2).
<3> The transimpedance amplifier (1) according to <1> or <2>, wherein
   the first voltage-current conversion circuit (3a) includes a second transistor (M2), and the second voltage-current conversion circuit (3b) includes a third transistor (M3),
   a voltage corresponding to the voltage converted by the first current-voltage conversion circuit (2a) is applied to gates or bases of the second transistor (M2) and the third transistor (M3), and
   currents converted by the first voltage-current conversion circuit (3a) and the second voltage-current conversion circuit (3b) are output from drains or collectors of the second transistor (M2) and the third transistor (M3).
<4> The transimpedance amplifier (1) according to any one of <1> to <3>, wherein
   the inverting amplifier circuit (4) includes:
   a fourth transistor (M4) having a gate or a base connected to an input node of the inverting amplifier circuit (4); and
   a third current-voltage conversion (I3) circuit connected to a drain or a collector of the fourth transistor (M4), wherein
   an output node of the inverting amplifier circuit (4) is the drain or the collector of the fourth transistor (M4).
<5> The transimpedance amplifier (1) according to any one of <1> to <4>, wherein
   the first current-voltage conversion circuit (I2) is connected to a drain or a collector of the first transistor (M1).
<6> The transimpedance amplifier (1) according to any one of <1> to <5>, further comprising
   a level shift circuit (5) that shifts a voltage converted by the first current-voltage conversion circuit (I4), and outputs the shifted voltage, wherein
   an output voltage of the level shift circuit (5) is applied to the first voltage-current conversion circuit (3a) and the second voltage-current conversion circuit (3b).
<7> The transimpedance amplifier (1) according to<6>, wherein
   the level shift circuit (5) includes:
   a fifth transistor (M5); and
   a current source (I4) connected to a source or an emitter of the fifth transistor (M5), wherein
   an input node of the level shift circuit (5) is connected to a gate or a base of the fifth transistor (M5), and an output node of the level shift circuit (5) is connected to a source or an emitter of the fifth transistor (M5).
<8> The transimpedance amplifier (1) according to <7>, wherein
   the current source (I4) is the first current-voltage conversion circuit (2a).
<9> The transimpedance amplifier (1) according to any one of <1> to <8>, wherein
   the inverting amplifier circuit (4) includes:
   a sixth transistor (M6) having a gate or a base connected to the input terminal (IN); and
   a fourth current-voltage conversion circuit (I6) connected to a drain or a collector of the sixth transistor (M6), and
   the drain or the collector of the sixth transistor (M6) is connected to the gate or the base of the first transistor (M1).
<10> The transimpedance amplifier (1) according to any one of <1> to <9>, wherein
   a part of the output current of the first voltage-current conversion circuit (3a) flows through the input terminal (IN), and at least a part of a remaining current of the output current of the first voltage-current conversion (3a) circuit flows through a current source (I1).
<11> The transimpedance amplifier (1) according to any one of <1> to <10>, wherein
   output currents of the first voltage-current conversion circuit (3a) and the second voltage-current conversion circuit (3b) are supplied via a common-gate or common-base amplifier circuit (M6, M7).
<12> The transimpedance amplifier (1) according to <11>, wherein
   the common-gate or common-base amplifier circuit (M6, M7) includes:
   a seventh transistor (M6) that controls the output voltage of the first voltage-current conversion circuit (3a) and the input terminal (IN); and
   an eighth transistor (M7) that controls the output voltage of the second voltage-current conversion circuit (3b) and the output terminal (OUT), and
   the seventh transistor (M6) and the eighth transistor (M7) have gates or bases connected to each other.
<13> A photodetection device (6) comprising:
   the transimpedance amplifier (1) according to any one of <1> to <12>;
   a photoelectric conversion circuit (7) that converts an optical signal into an electric signal; and
   a first resistor (Rm1) connected between the input terminal (IN) of the transimpedance amplifier (1) and an output node of the photoelectric conversion circuit (7).
<14> The photodetection device (6) according to <13>, further comprising
   a board wiring (8) connected between an output node of the photoelectric conversion circuit (7) and another end of the first resistor (Rm1).
<15> The photodetection device (6) according to <13> or <14>, further comprising
   a passive element (Rm2, Cm21) connected between the board wiring (8) and the output node of the photoelectric conversion circuit (7), wherein
   the passive element (Rm2, Cm21) is modified with a second capacitor (Cm22) and at least one of a second resistor (Rm22) or a third resistor(Rm21).
<16> The photodetection device (6) according to <13> or <14>, further comprising
   a passive element (Rm3, Cm3) connected to one end of the first resistor (Rm1), wherein
   the passive element (Rm3, Cm3) includes at least one of a fourth resistor (Rm3) or a first capacitor (Cm3).
<17> The photodetection device (6) according to <15>, wherein
   the passive element (Rm2, Cm21) includes at least one of a fourth resistor (Rm3) or a first capacitor (Cm3) connected to one end of the first resistor (Rm1).
<18> An electronic device (21) comprising:
   a light receiver (24) including the photodetection device (6) according to any one of <13> to <17>, the light receiver (24) being configured to receive second light including reflected light obtained by reflecting first light by an object (10); and
   a processing circuitry (62) configured to measure a distance to the object (10) based on a light projection timing of the first light and a light reception timing of the reflected light in the light receiver (24).
<19> The electronic device (21) according to <18>, further comprising
   a light projector (22) that projects the first light, wherein
   the processing circuitry (62) is configured to acquire a light projection timing of the first light.

## Claims

1. A transimpedance amplifier (1) comprising:
an input terminal (IN);
a first transistor (M1) having a source or an emitter connected to the input terminal (IN);
a first current-voltage conversion circuit (2a);
a first voltage-current conversion circuit (3a) and a second voltage-current conversion circuit (3b) that convert a voltage corresponding to an output voltage of the first current-voltage conversion circuit (2a) into a current;
an inverting amplifier circuit (4) having an input node connected to the source or the emitter of the first transistor (M1) and an output node connected to a gate or a base of the first transistor (M1);
a second current-voltage conversion circuit (2b) that converts an output current of the second voltage-current conversion circuit (3b) into a voltage; and
an output terminal (OUT) that outputs the voltage converted by the second current-voltage conversion circuit (2b), wherein
the output current of the first voltage-current conversion circuit (3a) is fed back to the source or the emitter of the first transistor (M1).

2. The transimpedance amplifier (1) according to claim 1, wherein
the first current-voltage conversion circuit (2a) and the second current-voltage conversion circuit (2b) each include at least one of a resistor (R1) and a current source (I2).

3. The transimpedance amplifier (1) according to claim 1 or claim 2, wherein
the first voltage-current conversion circuit (3a) includes a second transistor (M2), and the second voltage-current conversion circuit (3b) includes a third transistor (M3),
a voltage corresponding to the voltage converted by the first current-voltage conversion circuit (2a) is applied to gates or bases of the second transistor (M2) and the third transistor (M3), and
currents converted by the first voltage-current conversion circuit (3a) and the second voltage-current conversion circuit (3b) are output from drains or collectors of the second transistor (M2) and the third transistor (M3).

4. The transimpedance amplifier (1) according to any one of claim 1 to claim 3, wherein
the inverting amplifier circuit (4) includes:
a fourth transistor (M4) having a gate or a base connected to an input node of the inverting amplifier circuit (4); and
a third current-voltage conversion (I3) circuit connected to a drain or a collector of the fourth transistor (M4), wherein
an output node of the inverting amplifier circuit (4) is the drain or the collector of the fourth transistor (M4).

5. The transimpedance amplifier (1) according to any one of claim 1 to claim 4, wherein
the first current-voltage conversion circuit (I2) is connected to a drain or a collector of the first transistor (M1).

6. The transimpedance amplifier (1) according to any one of claim 1 to claim 5, further comprising
a level shift circuit (5) that shifts a voltage converted by the first current-voltage conversion circuit (I4), and outputs the shifted voltage, wherein
an output voltage of the level shift circuit (5) is applied to the first voltage-current conversion circuit (3a) and the second voltage-current conversion circuit (3b).

7. The transimpedance amplifier (1) according to claim 6, wherein the level shift circuit (5) includes:
a fifth transistor (M5); and
a current source (I4) connected to a source or an emitter of the fifth transistor (M5), wherein
an input node of the level shift circuit (5) is connected to a gate or a base of the fifth transistor (M5), and an output node of the level shift circuit (5) is connected to a source or an emitter of the fifth transistor (M5).

8. The transimpedance amplifier (1) according to claim 7, wherein
the current source (I4) is the first current-voltage conversion circuit (2a).

9. The transimpedance amplifier (1) according to any one of claim 1 to claim 8, wherein
the inverting amplifier circuit (4) includes:
a sixth transistor (M6) having a gate or a base connected to the input terminal (IN); and
a fourth current-voltage conversion circuit (I6) connected to a drain or a collector of the sixth transistor (M6), and
the drain or the collector of the sixth transistor (M6) is connected to the gate or the base of the first transistor (M1).

10. The transimpedance amplifier (1) according to any one of claim 1 to claim 9, wherein
output currents of the first voltage-current conversion circuit (3a) and the second voltage-current conversion circuit (3b) are supplied via a common-gate or common-base amplifier circuit (M6, M7).

11. A photodetection device (6) comprising:
the transimpedance amplifier (1) according to any one of claim 1 to claim 10;
a photoelectric conversion circuit (7) that converts an optical signal into an electric signal; and
a first resistor (Rm1) connected between the input terminal (IN) of the transimpedance amplifier (1) and an output node of the photoelectric conversion circuit (7).

12. The photodetection device (6) according to claim 11, further comprising
a board wiring (8) connected between an output node of the photoelectric conversion circuit (7) and another end of the first resistor (Rm1).

13. The photodetection device (6) according to claim 11 or claim 12, further comprising
a passive element (Rm2, Cm21) connected between the board wiring (8) and the output node of the photoelectric conversion circuit (7), wherein
the passive element (Rm2, Cm21) is modified with a second capacitor (Cm22) and at least one of a second resistor (Rm22) or a third resistor(Rm21).

14. The photodetection device (6) according to claim 11 or claim 12, further comprising
a passive element (Rm3, Cm3) connected to one end of the first resistor (Rm1), wherein
the passive element (Rm3, Cm3) includes at least one of a fourth resistor (Rm3) or a first capacitor (Cm3).

15. The photodetection device (6) according to claim 13, wherein
the passive element (Rm2, Cm21) includes at least one of a fourth resistor (Rm3) or a first capacitor (Cm3) connected to one end of the first resistor (Rm1).
